# EUROPEAN PATENT SPECIFICATION

(11) **EP 1 866 371 B1**
(45) Date of publication and mention of the grant of the patent: **08.09.2010**
(21) Application number: 06716979.7
(22) Date of filing: 08.03.2006
(51) Int. Cl.: C08L 63/00, C09D 11/10, C09D 163/00, G03F 7/038

(54) **ULTRAVIOLET CURING RESIN COMPOSITION**
UV-HÄRTBARE HARZZUSAMMENSETZUNG
COMPOSITION DE RESINE DURCISSANT AUX ULTRAVIOLETS

(30) Priority: 18.03.2005 SE 0500621
(43) Date of publication of application: 19.12.2007
(73) Proprietor: Perstorp Specialty Chemicals AB, 284 80 Perstorp (SE)
(72) Inventor: JAMES, David, S-281 33 Hassleholm (SE)
(74) Representative: HOFFMANN EITLE
(86) International application number: PCT/SE2006/000293
(87) International publication number: WO 2006/098676

(56) References cited:
- WO-A-98/36323
- WO-A-03/093901
- WO-A1-03/099947
- US-A1- 2002 081 506
- US-B1- 6 855 748

## Description

The present invention refers to a resin composition curable by ultraviolet light, which resin composition comprises at least one cycloaliphatic epoxy resin or epoxide compound, vinyl ether and/or oxetane, at least one polycarbonate diol, triol and/or polyol and at least one cationic photoinitiator, and optionally at least one sensitiser material sensitising and increasing the reactivity of said photoinitiator, at least one radical monomer or oligomer and/or at least one free radical photoinitiator. In a further aspect, the present invention refers to the use of said resin composition.

Cationic photopolymerisation is a ring opening polymerisation process of oxiranes and/or oxetanes initiated by a strong protonic acid generated by the photolysis of onium salts, such as diaryliodonium and/or triarylsulphonium salts. Photosensitisers, such as thioxanthones and anthracene derivatives, as well as free radical photoinitiators can be used to enhance the activity of the onium salt. The living character of the polymerisation will continue to develop after ultraviolet (UV) exposure, providing a beneficial post cure effect. This effect can be enhanced by a thermal treatment. The ring opening mechanism results in a low shrinkage and the outstanding adhesion on many substrates is one of the main features of cationic systems over free radical polymerisation. Furthermore, the oxonium ion and the carbocation are inactive towards oxygen which allows a high curing speed in air.

Cationic radiation curing resins are typically used in printing inks, varnishes, coatings, rapid prototyping, electronic coatings, insulation coatings and in adhesives.

The main components of cationic formulation are cycloaliphatic epoxy resins and/or epoxide compounds, such as 3,4-epoxy cyclohexyl methyl-3,4 epoxy cyclohexane carboxylate, as main compound and oxetanes, such as 3-ethyl-3-hydroxymethyl-oxetane, as reactive diluent.

The ring opening of the three membered epoxide group and/or the four membered oxetane group can be accompanied by crosslinking with hydroxyl functional compounds like caprolactone polyols, polyether polyols, polyester polyols, such as dendritic polymers. These polyols act as chain transfer crosslinkers and flexibilisers and they can be used in concentration up to for instance 30% by weight.

A number of other components, such as epoxides, that is epoxy and epoxide resins and compounds having one or more three membered epoxide groups, vinyl ethers, Novolac resins, epoxidized oils, epoxidized polybutadiene, can be used to fine tune the end properties of the coatings. The cationic polymerisation of expoxides, that is compounds and resins having one or more three membered epoxide groups, and oxetanes, that is compounds and resins having one or more four membered oxetane groups, can be combined, in a so called hybrid formulation, with free radical polymerisation of for instance acrylate systems to build interpenetrating polymer networks.

It is known for skilled in the art that current cationic inks, based on for instance hydrophilic polyethers or hydrolytically unstable polyester polyols and caprolactone polyols, are poor in withstanding the rigors of autoclave sterilisation processes due to poor hydrolytic and heat stability.

Low moisture sensitivity is a prerequisite for rapid prototyping resin compositions. The currently available polyols, such as caprolactones, polyether and polyester polyols, are known in the art to suffer from too high a hydrophilicity altering the mechanical properties of the prototype when exposed to different ambient conditions.

It is, furthermore, known in the art that the rheology of an ink is essential for obtaining good printing quality. Due to the overall high hydrophilicity of compounds used in cationic radiation curing, the ink is suffering from a strong pseuplastic behaviour when formulating with organic pigments. This is detrimental to the ink transfer and printing quality.

Aliphatic polycarbonate diols, triols and polyols have long been known. They are prepared from non-vicinal diols, triols and polyols by reaction with diarylcarbonates, dialkylcarbonates, dioxolanones, phosgene, bischlorocarbonic acid esters or urea. Polycarbonate diols, triols and polyols are outlined in Polymer Reviews 9 "Chemistry and Physics of Polycarbonates," pp. 9-20, 1964.

Many diols, triols and polyols can be used in the transcarbonylation process in the preparation of polycarbonates polyols. Examples of suitable diols, triols and polyols include, but are not limited to, 1,4-butanediol, 1,5-pentanediol, 3-methyl-1,5-pentanediol, 1,6-hexanediol, neopentylglycol, 2-butyl-2-ethyl-1,3-propanediol, trimethylolethane, trimethylolpropane, pentaerythrytol, di-trimethylolpropane, dipentaeryhtritol, hyperbanched polymer polyols and the like. Further suitable diols, triols and polyols include alkoxylated species of for instance neopentyl glycol, 2-butyl-2-ethyl-1,3-propanediol, trimethylolethane, trimethylolpropane, pentaerythritol, ditrimethylolethane, ditrimethylolpropane and dipentaerythritol. Mixtures of polyols can be used, and mixtures are often preferred when physical property modifications, such as reduced crystallinity or a lower melting point is desired.

Polyether diols, such as polyethylene glycol and polypropylene glycol, and polyester diols and polyols, such as polyethylene glycol adipate, and dendritic and branched polyols are also suitable hydroxyfunctional compounds. Block copolymers of polyethers or polyesters and polycarbonates can be prepared using these diols, triols and polyols as starting materials in the transesterification process.

Polycarbonate diols, triols and polyols offer outstanding resistance to hydrolysis making them particularly suitable in the production of long life articles. The advantages of the use of polyolcarbonates for exterior coating applications have in US 6,350,523 been disclosed in free radical radiation curable coatings. The resistance to heat and hydrolysis of diol, triol and polyol carbonates has in JP 2003-246830 been disclosed in hot melt urethane adhesives.

WO 03/093901 discloses a dual curing system for prototyping comprising, relative to the total weight of the composition, 0-29 wt.% of a cationically curable component having a linking aliphatic ester group, 10-85 wt.% of an epoxy group-containing component other than the cationically curable component, 1-50 wt.% of an oxetane group-containing component, 1-25 wt.% of a multifunctional acrylate, a radical photoinitiator and a cationic photoinitiator.

The objects of the invention is the use of polyolcarbonates as chain transfer crosslinkers and flexibilisers in cationic actinic polymerisation protective coatings, inks, adhesives, rapid prototyping and electronics. A further embodiment is the superior outdoor durability, heat and hydrolytic stability of the Formulations based on these polycarbonate polyols for cationic ultraviolet or electron beam (UV/EB) curing coatings compared to formulations based on polyester polyols, caprolactone polyols and polyether polyols. The present compositions are suitable for a wide variety of applications. The better hydrolytic stability provides superior ink properties for demanding conditions like packagings withstanding sterilisation and pasteurisation process. Further benefits like improved rheology of pigmented systems have been found when using hydrophobic diol, triol or polyol carbonates leading to superior ink transfer and printing quality. The high hydrophobicity makes these diol, triol or polyol carbonates very suitable in stable resin compositions for rapid prototyping.

The active energy radiation curing resin composition of the present invention comprises in its simplest form an epoxy functional monomer or polymer, an oxetane compound, a polycarbonate diol, triol or polyol and a photocationic polymerisation initiator. Above composition can optionally be combined with free radical components, such as (meth)acrylates and vinyl ethers, and other unsaturated compounds and a suitable free radical photoinitiator, yielding a so called hybrid system.

These formulations can be used as or in protective coatings, inks and adhesives as well as in electronic, rapid prototyping and ink jet applications. The polycarbonate diol, triol or polyol provides for example coatings with superior outdoor durability, heat and moisture resistance and improved dimensional stability and stable mechanical properties in rapid prototyping systems and adhesives, improved hydrolytic stability in sterilisation and pasteurisation of printing inks and varnishes as well improved rheological behaviour, such as more Newtonian behaviour, in inks.

The present invention accordingly refers to a resin composition curable by ultraviolet light, which resin composition comprises:
a) 25-95% by weight of at least one cycloaliphatic epoxy or epoxide resin or compound, which resin or compound has one or more three membered epoxide groups, at least one vinyl ether and/or at least one oxetane resin or compound having one or more four membered oxetane groups and/or a mixture thereof,
b) 1-40% by weight of at least one polycarbonate diol, triol and/or polyol wherein the diol, triol and/or polyol is selected from 1,4-butanediol, neopentyl glycol, 2-butyl-2-ethyl-1,3-propanediol, diethylene glycol, 1,6-hexanediol, triethylene glycol, 1,3-dimethanol-cyclohexane, 1,4-dimethanol-cyclohexane, dimethanoltricyclodecane, trimethlylolethane, trimethylolpropane, pentaerythritol, ditrimethylolethane, ditrimethylolpropane, dipentaerythritol and/or anhydroenneaheptitol,
c) 0.1-10% by weight of at least one cationic photoinitiator, and optionally
d) 1-70% by weight of at least one radically polymeriserable monomer or oligomer and/or a mixture thereof, and/or
e) 0.1-10% by weight of at least one free radical photoinitiator.

Said cycloaliphatic epoxy resin or epoxide compound is preferably and typically a resin or compound having a linking aliphatic ester group and two cyclohexene oxide groups, such as 3,4-epoxy-6-methylcyclohexylmethyl-3,4-epoxy-6-methylcyclohexanecarboxylate, di(3,4--epoxycyclohexylmethyl)hexanedioate, di(3,4-epoxy-6-methylcyclohexylmethyl)hexane-dioate, 3,4-epoxycyclohexylmethyl-3,4-epoxycyclohexanecarboxylate and ethylenebis-(3,4-epoxycyclohexanecarboxylate).

Said oxetane resin or compound is in various embodiments of said resin composition preferably selected from the group consisting of 3-ethyl-3-hydroxymethyloxetane, 3-(meth)allyloxymethyl-3-ethyloxetane, (3-ethyl-3-oxetanylmethoxy)methylbenzene, (3-ethyl--3-oxetanylmethoxy)-benzene, 4-fluoro-[1-(3-ethyl-3-oxetanylmethoxy)methyl]benzene, 4-methoxy-[1-(3-ethyl-3-oxetanylmethoxy)methyl]benzene, [1-(3-ethyl-3-oxetanylmethoxy)-ethyl]phenylether, isobutoxymethyl(3-ethyl-3-oxetanylmethyl)ether, isobornyloxyethyl-(3-ethyl-3-oxetanyl-methyl)ether, isobornyl(3-ethyl-3-oxetanylmethyl)ether, 2-ethylhexyl-(5-ethyl-3-oxetanylmethyl) ether, ethyldiethyleneglycol(3-ethyl-3-oxetanylmethyl)ether, dicyclopentzdiene-(3-ethyl-3-oxetanylmethyl)ether, dicyclopentenyloxyethyl(3-ethyl-3--oxetanylmethyl)ether, dicyclopentenyl(3-ethyl-3-oxetanylmethyl)ether, tetrahydrofurfuryl-(3-ethyl-3-oxetanylmethyl) ether, tetrabromophenyl(3-ethyl-3-oxetanylmethyl)ether, 2-tetrabromophenoxyethyl-(3-ethyl-3-oxetanylmethyl)ether, tribromophenyl(3-ethyl--3-oxetanylmethyl)ether, 2-tribromophenoxyethyl(3-ethyl-3-oxetanylmethyl)ether, 2-hydroxyethyl(3-ethyl-3-oxetanylmethyl)ether, 2-hydroxypropyl(3-ethyl-3-oxetanyl-methyl)ether, butoxyethyl(3-ethyl-3-oxetanylmethyl)ether, pentachlorophenyl-(3-ethyl--3-oxetanylmethyl)ether, pentabromophenyl(3-ethyl-3-oxetanylmethyl) ether, bornyl-(3-ethyl-3-oxetanylmethyl)ether, 3,7-bis(3-oxetanyl)-5-oxa-nonane, 3,3'-(1,3-(2-methylenyl)-propanediylbis(oxymethylene))-bis(3-ethyloxetane), 1,4-bis[(3-ethyl-3-oxetanylmethoxy)-methyl]benzene, 1,2-bis[(3-ethyl-3-oxetanylmethoxy)methyl]ethane, 1,3-bis[(3-ethyl-3--oxetanylmethoxy)methyl]propane, ethyleneglycolbis(3-ethyl-3-oxetanylmethyl)ether, dicyclo pentenylbis-(3-ethyl-3-oxetanylmethyl)ether, triethyleneglycolbis(3-ethyl-3-oxetanyl-methyl)ether, tetraethyleneglycolbis(3-ethyl-3-oxetanylmethyl)ether, tricyclodecanediyldimethylene-(3-ethyl-3-oxetanylmethyl)ether, trimethylolpropanetris(3-ethyl-3-oxetanyl-methyl)ether, 1,4-bis(3-ethyl-3-oxetanyhnethoxy)butane, 1,6-bis(3-ethyl-3-oxetanylmethoxy)-hexane, pentaerythritoltris(3-ethyl-3-oxetanylmethyl)ether, pentaerythritoltetrakis(3-ethyl-3--oxetanylmethyl)ether, polyethyleneglycolbis(3-ethyl-3-oxetanylmethyl)ether, dipentaerythritolhexakis-(3-ethyl-3-oxetanylmethyl)ether, dipentaerythritolpentakis--(3-ethyl-3-oxetanylmethyl)ether, dipentaerythritoltetrakis(3-ethyl-3-oxetanylmethyl)ether, caprolactone modified dipentaerythritolhexakis(3-ethyl-3-oxetanylmethyl)ether, caprolactone modified dipentaerythritolpentakis(3-ethyl-3-oxetanylmethyl)ether, ditrimethylolpropane-tetrakis-(3-ethyl-3-oxetanylmethyl)ether, ethylene oxide modified bisphenol-A-bis(3-ethyl-3--oxetanyhnethyl)ether, propylene oxide modified bisphenol-A-bis(3-ethyl--3-oxetanylmethyl)ether, ethylene oxide modified hydrogenated bisphenol-A-bis-(3-ethyl-3-oxetanylmethyl)ether, propylene oxide modified hydrogenated bisphenol-A--bis(3-ethyl-3-oxetanylmethyl)ether and/or ethylene oxide modified bisphenol-F-(3-ethyl-3-oxetanylmethyl)ether.

A vinylether compound is in embodiments of the present invention advantageously selected among divinyl or trivinyl ether compounds, such as ethylene glycol divinyl ether, ethylene glycol monovinyl ether, diethylene glycol divinyl ether, triethylene glycol monovinyl ether, triethylene glycol divinyl ether, propylene glycol divinyl ether, dipropylene glycol divinyl ether, butanediol divinyl ether, hexanediol divinyl ether, cyclohexane dimethanol divinyl ether, hydroxyethyl monovinyl ether, hydroxynonyl monovinyl ether and trimethylolpropane trivinyl ether, and monovinyl ether compounds such as ethylvinylether, n-butylvinylether, *iso*-butylvinylether, octadecylvinylether, cyclohexylvinylether, hydroxybutylvinylether, 2-ethylhexylvinylether, cyclohexanedimethanolmonovinylether, *n*-propylvinylether, isopropylvinylether, isopropenylether-*o*-propylenecarbonate, dodecylvinylether, diethyleneglycolmonovinylether, octadecylvinylether and the like.

Polycarbonate diols, triols and polyols included in the resin composition of the present invention are suitably and for example produced in a transesterification process as disclosed in US 5,171,830 which disclosure in its entirety by reference is herein is included. Polycarbonate diols, triols and polyols possible to include in said resin composition are, however, not limited to polycarbonates prepared by said process. Diols, triols and polyols suitable for preparation of said polycarbonates are 1,4-butanediol, neopentyl glycol, 2-butyl-2-ethyl-1,3-propanediol, diethylene glycol, 1,6-hexanediol, triethylene glycol, 1,3-dimethanol-cyclohexane, 1,4-dimethanol-cyclohexane, dimethanoltricyclodecane, trimethlylolethane, trimethylolpropane, pentaerythritol, ditrimethylolethane, ditrimethylolpropane, dipentaerythritol and/or anhydroenneaheptitol.

Any suitable type of photoinitiator that upon exposure to actinic radiation forms cations that initiating the reactions of the cationically polymerisable compounds, such as epoxy resins, can be used in the resin composition of the present invention. There is a large number of know and technically proven cationic photoinitiators that are suitable. They include, for example, onium salts with anions having a weak nucleophilicity. Examples are halonium salts, iodosyl salts and sulphonium salts, such as those disclosed in the European patent application 0 153 904 and in WO 98/28663, sulphoxonium salts, such as those disclosed in the European patent applications 0 035 969, 0 044 274, 0 054 509 and 0 164 314, and diazonium salts, such as those disclosed in US Patents 3,708,296 and 5,002,856 and in GB 2396153. All of these eight disclosures are hereby incorporated in their entirety by reference. Further cationic photoinitiators are for instance metallocene salts, such as those disclosed in European applications EP 0 094 914 and 0 094 915, which disclosures hereby also are incorporated in their entirety by reference.

A survey of other currently available onium salt initiators and/or metallocene salts can be found in "UT Curing, Science and Technology", Editor S.P. Pappas, Technology Marketing Corp., USA and in "Chemistry & Technology of UV & EB Formulation for Coatings, Inks & Paints", Vol. 3, edited by P.K.T. Oldring.

Said optional radically polymerisable monomer or oligomer can be exemplified by and in embodiments of the present resin composition include ethylene glycol di(meth)acrylate, dicyclopentenyl di(meth)acrylate, triethylene glycol diacrylate, tetraethylene glycol di(meth)acrylate, tricyclodecanediyldimethylene di(meth)acrylate, trimethylolpropane tri(meth)acrylate, alkylene oxide, such as ethylene and/or propylene oxide, modified trimethylolpropane tri(meth)acrylate, tripropylene glycol di(meth)acrylate, neopentyl glycol di(meth)acrylate, alkylene oxide modified neopentyl glycol di(meth)acrylate, such as ethylene oxide modified neopentyl glycol di(meth)acrylate and propylene oxide modified neopentyl glycol di(meth)acrylate, (meth)acrylic adducts of bisphenol A diglycidyl ether, 1,4-butanediol di(meth)acrylate, 1,6-hexanediol di(meth)acrylate, pentaerythritol tri(meth)acrylate, pentaerythritol tetra(meth)acrylate, alkylene oxide, such as ethylene oxide and/or propylene oxide, modified pentaerythritol tri(meth)acrylate and tetra(meth)acrylate, polyethylene glycol di(meth)acrylate, dipentaerythritol hexa(meth)acrylate, dipentaerythritol penta(meth)acrylate, dipentaerythritol tetra(meth)acrylate, alkylene oxide, such as ethylene and/or propylene oxide modified dipentaerythritol hexa(meth)acrylate, penta(meth)acrylate and tetra(meth)acrylate, ditrimethylolpropane tetra(meth)acrylate, alkylene oxide, such as ethylene oxide and/or propylene oxide, modified ditrimethylolpropane tetra(meth)acrylate, alkylene oxide, such as ethylene and/or propylene oxide, modified bisphenol A, hydrogenated bisphenol A and bisphenol F di(meth)acrylate, (meth)acrylates of phenolic novolak polyglycidyl ethers and the like.

The resin compositions of the present invention may in embodiments thereof employ one or more free radical photoinitiators. Examples of such photoinitiators include benzoin and benzoin derivatives, such as benzoin methyl ether, benzoin ethyl ether, benzoin isopropyl ether, benzoin phenyl ether and benzoin acetate, acetophenones, such as acetophenone, 2,2-dimethoxyacetophenone, 4-(phenylthio)acetophenone and 1,1-dichloroacetophenone, benzil and benzil ketals, such as benzil dimethyl ketal and benzil diethyl ketal, anthraquinones, such as 2-methylanthraquinone, 2-ethylanthraquinone, 2-tertbutylanthraquinone, 1-chloroanthraquinone and 2-amylanthraquinone, triphenylphosphine, benzoylphosphine oxides, such as 2,4,6-trimethylbenzoyldiphenylphosphine oxide, benzophenones, such as benzophenone, dimethoxybenzophenone, diphenoxybenzophenone and 4,4'-bis (N,N'-dimethylamino)benzophenone, thioxanthones and xanthones, acridine derivatives, phenazene derivatives, quinoxaline derivatives, I-phenyl-1, 2-propanedione--2-O-benzoyloxime, I-aminophenyl ketones and 1-hydroxyphenyl ketones, such as 1-hydroxycyclohexylphenyl ketone, phenyl(1-hydroxyisopropyl) ketone and 4-isopropylphenyl-(1-hydroxyisopropyl) ketone, and triazine compounds, such as, 4"'-methylthiophenyl-1-di(trichloromethyl)-3, 5-S-triazine, S-triazine-2-(stilbene)-4, 6-bistrichloromethyl and paramethoxy styryl triazine.

The resin composition of the present invention may additionally comprise at least one organic or inorganic pigment, filler and/or colorant, all well known *per se* in the art. Non-limiting examples of typically suitable organic colorants include phthalocyanine blue, monoarylide yellow, diarylide yellow, arylamide yellow, azored, quinacridone magenta and black pigments, such as finely divided carbon and the like.

Stabilisers may be added to the compositions in order to prevent for instance viscosity build-up, such as a viscosity build-up when used in a solid imaging process. Preferred stabilisers include those disclosed in US Patent 5,665,792 of which the entire disclosure is hereby incorporated by reference. Such stabilisers are usually hydrocarbon carboxylic acid salts of group IA and IIA metals. The most preferred examples of these salts are sodium bicarbonate, potassium bicarbonate and rubidium carbonate. Furthermore, one or more sensitisers, such as 1-chloro-4-propoxy-thioxanthone, in an amount of for instance 0.1-5.0% by weight, sensitising the cationic photoinitiators and thus increase its reactivity, may also be added to the resin composition according to the present invention.

In a further aspect, the present invention refers to the use of a resin composition, as herein disclosed, decorative and/or protective coatings, varnishes, inks, such as printing inks, and adhesives as well as in rapid prototyping compositions.

Without further elaboration, it is believed that one skilled in the art can, using the preceding description, utilise the present invention to its fullest extent. The following preferred specific embodiments are, therefore, to be construed as merely illustrative and not limitative of the remainder of the disclosure in any way whatsoever. In the following Examples 1 and 2 refer to synthesis of polycarbonat diols used in embodiments of the present invention and Examples 3-6 to preparation and evaluation of resin compositions, coatings and inks, according to embodiments of said invention. Evaluation results are given in Tables 1 and 2.

### Example 1

The synthesis is performed in two steps, a transcarbonylation step at atmospheric pressure followed by a polymerisation step at a reduced pressure. The transcarbonylation, by which dimethylcarbonate (DMC) forms the mono and dimethylcarbonate esters of neopentyl glycol, is performed to avoid losses of DMC in the polymerisation step due to the azeotrop formed with methanol. The synthesis gave a yield of more than 90% polycarbonate of neopentyl glycol, which product was a white solid with melting range of 100-110°C and a hydroxyl value of 112 mg KOH/g.
Step 1: 169 g (1.88 mole) of DMC and 140 g (1.34 mole) of neopentyl glycol were charged to a 500 ml glass reactor provided with heating and stirring. 1.07 g (0.013 mole) of NaOH (50% in water) was slowly added drop wise when the neopentyl glycol began to go into solution. The mixture was set to reflux at a starting temperature of 94°C. Formed methanol and remaining DMC were distilled of under atmospheric pressure when the temperature reached 81°C. The distillation temperature interval was 82-124°C.
Step 2: In this polymerisation step the pressure was during 25 minutes reduced to 7 mbar and the reaction was completed by maintaining said pressure for 60 minutes at 120°C.

### Example 2

The synthesis is performed in two steps, a transcarbonylation step at atmospheric pressure followed by a polymerisation step at a reduced pressure. The transcarbonylation, by which dimethylcarbonate (DMC) forms the mono and dimethylcarbonate esters of 2-butyl-2-ethyl-1,3-propanediol (BEPD), is performed to avoid losses of DMC in the polymerisation step due to the azeotrop formed with methanol. The synthesis gave a yield of more than 90% polycarbonate of BEPD, which product was liquid at room temperature with a hydroxyl value of 112 mg KOH/g.
Step 1: 126.1 g (1.4 mole) of DMC and 162.25 g (1.34 mole) of BEPD were charged to a 500 ml glass reactor provided with heating and stirring. 0.04 g (0.0005 mole) of NaOH (50% in water) was slowly added drop wise when the neopentyl glycol began to go into solution. The mixture was set to reflux at a starting temperature of 99°C. Formed methanol and remaining DMC were distilled of under atmospheric pressure when the temperature reached 81°C.
Step 2: In this polymerisation step the pressure was during 25 minutes reduced to 15 mbar and the reaction was completed by maintaining said pressure for 270 minutes at 120°C.

### Example 3

Resin compositions, clear coatings, according to embodiments of the present invention and comprising the products obtained in Examples 1 and 2 (Embodiment Formulations 3 and 4) were prepared and compared with clear coatings without said Example 1 and 2 products (Formulation 1 and 2). Components and amounts thereof are listed below.

| **Formulation no.** | **1** | **2** | **3** | **4** |
|---|---|---|---|---|
| UVR 6110*1 | 80 | 70 | 70 | 70 |
| Tone 0305 *2 | 15 | 15 | --- | --- |
| UVR 6992 *3 | 5 | 5 | 5 | 5 |
| TMPO *4 | --- | 10 | 10 | 10 |
| Neopentyl glycol polycarbonate, Example 1 | --- | --- | 10 | --- |
| BEPD polycarbonate, Example 2 | --- | --- | --- | 15 |

| | | | | |
|---|---|---|---|---|
| *1: Cycloaliphatic epoxy resin (Dow Chemicals, USA). *2: Caprolactone polyol (Dow Chemicals, USA). *3: Triarylsulphonium salt (photoinitiator, Dow Chemicals, USA). *4: 3-Ethyl-3-hydroxymethyloxetane (Perstorp Specialty Chemicals AB, Sweden). | | | | |

### Example 4

The resin compositions, clear coatings, prepared in Example 3 were applied on glass panels (film thickness: 15 µm wet). The coatings were cured in air by being passed twice under a 80 W/cm UV H bulb at a speed of 10 m/min and characterised by methylethyl keton (MEK) double rubs, pendulum hardness (König pendulum) according to ASTM D4366-95 and Erichsen flexibility according to ASTM E-643. The viscosity was measured by a cone and plate viscosimeter at 25°C. The result is given in Table 1 below.

### Example 5

Resin compositions, inks, according to embodiments of the present invention and comprising the product obtained in Example 2 (Embodiment Formulations 5, 7 and 9) were prepared and compared with inks without said Example 2 product (Formulations 6, 8 and 10). All inks were prepared at 50°C in a high speed dispersing equipment. Components and amounts thereof are listed below.

| **Formulation no.** | **5** | **6** | **7** | **8** | **9** | **10** |
|---|---|---|---|---|---|---|
| Cyracure 6110 *1 | 52.3 | 52.3 | 52.3 | 52.3 | 52.3 | 52.3 |
| TMPO | 14.8 | 14.8 | 14.8 | 14.8 | 14.8 | 14.8 |
| Tone 0305 *2 | -- | 10.8 | -- | 10.8 | -- | 10.8 |
| BEPD polycarbonate, Example 2 | 10.8 | -- | 10.8 | -- | 10.8 | -- |
| Solsperse 2400 *3 | 1.0 | 1.0 | 1.0 | 1.0 | 1.0 | 1.0 |
| Violet PV RL *4 | 14.0 | 14.0 | -- | -- | -- | -- |
| Orange STD04RL *4 | -- | -- | 14.0 | 14.0 | -- | -- |
| Orange Irgalite F2G *5 | -- | -- | -- | -- | 14.0 | 14.0 |
| Irgacure 250 *6 | 5.5 | 5.5 | 5.5 | 0.5 | 5.5 | 5.5 |
| CPTX *7 | 0.5 | 0.5 | 0.5 | 0.5 | 0.5 | 0.5 |
| Irgacure 2959 *8 | 0.5 | 0.5 | 0.5 | 0.5 | 0.5 | 0.5 |
| BYK 305 *9 | 0.6 | 0.6 | 0.6 | 0.6 | 0.6 | 0.6 |

| | | | | | | |
|---|---|---|---|---|---|---|
| *1: Cycloaliphatic epoxy (Dow Chemicals, USA). *2: Caprolactone polyol (Dow Chemicals, USA). *3: Dispersing agent (Lubrizol, Germany). *4: Organic pigments (Clariant, Switzerland). *5: Organic pigment (CIBA, Switzerland). *6: Iodonium salt (photoinitiator, CIBA, Switzerland). *7: I-Chloro-4-propoxythioxanthone (sensitiser, Lambson Ltd, UK). *8: Free radical photoinitiator (Ciba, Switzerland). *9: Wetting agent (Byk Chemie GmbH, Germany). | | | | | | |

### Example 6

The rheology of the resin compositions, inks, prepared in Example 5 were evaluated with a Stresstech viscosimeter and the shortness index was measured. The shortness index is the viscosity ratio between low shear and high shear rates (herein 2.5 s-1 and 2500 s-1). A. shortness index of 1 represents a Newtonian behaviour and the higher the shortness index, the higher the pseudoplasticity of the ink. The viscosity at a shear rate of 369 s-1 is given in Table 2 below wherein can be seen that resin compositions, inks, according to the present invention exhibit much lower shortness index compared with inks without said BEPD carbonate.

**Table 1**

| **Formulation no.** | **1** | **2** | **3** | **4** |
|---|---|---|---|---|
| Pendulum hardness, König secs. | 150 | 231 | 205 | 196 |
| Erichsen flexibility, mm | 5.8 | 5.8 | . 5.0 | 4.5 |
| MEK rubs directly after cure | 2 | 2 | 2 | 2 |
| MEK rubs after 1 hr. | 16 | 28 | 11 | 10 |
| MEK rubs after 3 hrs. | 31 | 102 | 30 | 30 |
| MEK rubs after 6 hrs. | 98 | 125 | 55 | 58 |
| MEK rubs after 24 hrs. | 125 | 186 | 95 | 97 |
| Viscosity, cone-plate at 25°C, mPas | 460 | 280 | 350 | 760 |

**Table 2**

| **Formulation no.** | **5** | **6** | **7** | **8** | **9** | **10** |
|---|---|---|---|---|---|---|
| Shortness index | 39 | 65 | 40 | 52 | 20 | 30 |
| Viscosity at 25°C, 369 s-1, mPas | 770 | 790 | 880 | 1 100 | 720 | 590 |

## Claims

1. A resin composition curable by ultraviolet light comprising:
a) 25-95% by weight of at least one cycloaliphatic epoxy or epoxide resin or compound, which resin or compound has one or more three membered epoxide groups, at least one vinyl ether and/or at least one oxetane resin or compound having one or more four membered oxetane groups and/or a mixture thereof,
b) 1-40% by weight of at least one polycarbonate diol, triol and/or polyol wherein the diol, triol and/or polyol is selected from 1,4-butanediol, neopentyl glycol, 2-butyl-2-ethyl-1,3-propanediol, diethylene glycol, 1,6-hexanediol, triethylene glycol, 1,3-dimethanol-cyclohexane, 1,4-dimethanol-cyclohexane, dimethanoltricyclodecane, trimethlylolethane, trimethylolpropane, pentaerythritol, ditrimethylolethane, ditrimethylolpropane, dipentaerythritol and/or anhydroenneaheptitol,
c) 0.1-10% by weight of at least one cationic photoinitiator, and optionally
d) 1-70% by weight of at least one radically polymeriserable monomer or oligomer and/or a mixture thereof, and/or
e) 0.1-10% by weight of at least one free radical photoinitiator.

2. A resin composition according to Claim 1, wherein said cycloaliphatic epoxy or epoxide resin or compound is a 4-epoxycyclohexylmethyl-3,4-epoxycyclohexane carboxylate, a 3,4-epoxy-1-methyl-cyclohexyl methyl-3,4-epoxy-1-methylcyclohexane carboxylate, a 6-methyl-3,4-epoxycyclohexymethyl-6-methyl-3,4-epoxycyclohexane carboxylate, a 3,4-epoxy-3-methylcyclohexylmethyl-3,4-epoxy-3-methylcyclohexane carboxylate and/or a 3,4-epoxy-5-methylcyclohexylmethyl-3,4-epoxy-5-methylcyclohexane carboxylate.

3. A resin composition according to Claim 1 or 2, wherein said oxetane resin or compound is a 3-ethyl-3-hydroxymethyloxetane, a 3-ethyl-3-phenoxymethyloxetane, a bis(1-ethyl(3-oxetanil))methyl)ether, a 3-ethyl-3-(2-ethylhexyloxy)methyl)oxetane, a 1,4-bis((3-ethyl-3-oxetanylmethoxy)methyl)-benzene, a phenol Novolak oxetane and/or a 3-ethyl-(triethoxysilylpropoxy)-methyl)oxetane.

4. A resin composition according to any preceding claim, wherein said vinyl ether is a divinyl, a trivinyl and/or a higher functionality vinyl ether.

5. A resin composition according to any preceding claim, wherein said vinyl ether is ethylene glycol divinyl ether, ethylene glycol monovinyl ether, diethyleneglycol divinyl ether, triethylene glycol monovinyl ether, triethylene glycol divinyl ether, propylene glycol divinyl ether, dipropylene glycol divinyl ether, butanediol divinyl ether, hexanediol divinyl ether, cyclohexane dimethanol divinyl ether, hydroxyethyl monovinyl ether, hydroxynonyl monovinyl ether and trimethylolpropane trivinyl ether, and monovinyl ether compounds such as ethylvinylether, n-butylvinylether, isobutylvinylether, octadecylvinylether, cyclohexylvinylether, hydroxybutylvinylether, 2-ethylhexylvinylether, cyclohexane-dimethanol monovinyl ether, *n*-propylvinylether, *iso*-propylvinylether, *iso*-propenyl ether, o-propylene carbonate, dodecylvinylether, diethyleneglycol monovinyl ether and/or octadecylvinylether.

6. A resin composition according to any preceding claim, wherein said polycarbonate diol, triol or polyol is obtainable by reacting at least one alkyl carbonate with at least one said diol, triol and/or polyol.

7. A resin composition according to Claim 6, wherein said alkyl carbonate is dimethyl carbonate and/or diethyl carbonate.

8. A resin composition according to any preceding claim, wherein said polycarbonate diol is a 2-butyl-2-ethyl-1,3-propanediol polycarbonate or a copolymer polycarbonate wherein said diol is 2-butyl-2-ethyl-1,3-propanediol in combination with at least one other diol, triol and/or polyol.

9. A resin composition according to any preceding claim, wherein said at least one cationic photoinitiator is an iodonium, a sulphonium, a halonium, a sulphoxonium, a diazonium and/or a metallocene salt.

10. A resin composition according to any preceding claim, further comprising at least one organic or inorganic pigment, filler and/or colorant.

11. A resin composition according to any preceding claim, wherein said optional radically polymeriserable monomer or oligomer is an acrylate monomer or oligomer.

12. A resin composition according to Claim 11, wherein said acrylate monomer is hexanediol di(meth)acrylate, trimethylolpropane tri(meth)acrylate, alkylene oxide modified glycerol tri(meth)acrylate, alkylene oxide modified neopentyl glycol di(meth)acrylate, alkylene oxide modified trimethylolpropane tri(meth)acrylate, alkylene oxide modified pentaerythritol tetra(meth)acrylate, ditrimethylolpropane tetra(meth)acrylate and/or dipentaerythritol penta(meth)acrylate.

13. A resin composition according to Claim 11, wherein said acrylate oligomers is an epoxy (meth)acrylate, a polyester (meth)acrylate, a polyether (meth)acrylate, a melamine (meth)acrylate, a urethane (meth)acrylate, a polycarbonate (meth)acrylate, a dendritic (meth)acrylate and/or an unsaturated polyester.

14. A resin composition according to any preceding claim, wherein said optional free radical photoinitiators is benzoin or a benzoin derivative, acetophenone, benzil or a benzil ketal, an anthraquinone, triphenylphosphine, a benzoylphosphine oxides, a benzophenone, a thioxanthone, a xanthones, an acridine derivative, a phenazene derivative and/or a quinoxaline derivative.

15. A resin composition according to any preceding claim, further comprising at least one sensitiser sensitising said at least one cationic photoinitiator thus increasing its reactivity.

16. A resin composition according to Claim 15, wherein said sensitiser is present in an amount of for instance 0.1-5.0% by weight.

17. A resin composition according to Claim 15 or Claim 16 wherein said sensitiser is 1-chloro-4-propoxy-thioxanthone.

18. A resin composition according to any preceding claim, further comprising at least one stabiliser, such as at least one hydrocarbon carboxylic acid salt of a group IA or IIA metal.

19. A resin composition according to Claim 18, wherein said stabiliser is sodium bicarbonate, potassium bicarbonate and/or rubidium carbonate.

20. A resin composition according to any preceding claim, wherein said at least one polycarbonate diol is neopentyl glycol polycarbonate diol or 2-butyl-2-ethyl-1,3-propanediol polycarbonate diol.

21. A resin composition according to any preceding claim, wherein it is a decorative and/or protective coating or varnish composition, an ink, such as a printing ink, composition, or an adhesive composition.

22. A resin composition according to any of Claims 1-20, wherein it is a rapid prototyping composition.

23. Use of a resin composition according to any of Claims 1-20, in a decorative and/or protective coating or varnish, in an ink, or in an adhesive.

24. Use of a resin composition according to any of Claims 1-20, for rapid prototyping.

## Patentansprüche

1. Harzzusammensetzung, die durch ultraviolettes Licht härtbar ist und die folgendes umfasst:
(a) 25 bis 95 Gew.% mindestens einer cycloaliphatischen Epoxyverbindung oder eines Epoxidharzes oder einer Verbindung, die ein Harz oder eine Verbindung mit einer oder mehreren dreigliedrigen Epoxidgruppen ist, mindestens einen Vinylether und/oder mindestens ein Oxetanharz oder eine Verbindung mit einer oder mehreren viergliedrigen Oxetangruppen und/oder eine Mischung davon,
(b) 1 bis 40 Gew.% mindestens eines Polycarbonatdiols, Triols und/oder Polyols, wobei das Diol, Triol und/oder Polyol ausgewählt ist aus 1,4-Butandiol, Neopentylglycol, 2-Butyl-2-ethyl-1,3-propandiol, Diethylenglyclol, 1,6-Hexandiol, Triethylenglycol, 1,3-Dimethanolcyclohexan, 1,4-Dimethanocyclohexan, Dimethanolcyclohexan, Dimethanoltricyclodecan, Trimethylolethan, Trimethylolpropan, Pentaerythritol, Ditrimethylolethan, Ditrimethylolethan, Ditrimethylolpropan, Dipentaerythritol und/oder Anhydroenneaheptitol,
(c) 0,1 bis 10 Gew.% mindestens eines kationischen Fotoinitiators und wahlweise
(d) 1 bis70 Gew.% mindestens eines radikalischen polymerisierbaren Monomers oder Oligomers und/oder eine Mischung daraus, und/oder
(e) 0,1 bis 10 Gew.% mindestens eines freien Radikalfotoinitiators.

2. Harzzusammensetzung gemäß Anspruch 1, wobei die cycloaliphatische Epoxyverbindung oder das Epoxidharz oder die Verbindung ein 4-Epoxycyclohexylmethyl-3,4-epoxycyclohexancarboxylat, ein 3,4-Epoxy-1-methyl-cyclohexylmethyl-3,4-epoxy-1-methylcyclohexancarboxylat, ein 6-Methyl-3,4-expoxycyclohexymethyl-6-methyl-3,4-epoxycyclohexancarboxylat, ein 3,4-Epoxy-3-methylcyclohexylmethyl-3,4-epoxy-4-methylcyclohexancarboxylat und/oder ein 3,4-Epoxy-5-methylcyclohexylmethyl-3,4-epoxy-5-methylcyclohexancabroxylat ist.

3. Harzzusammensetzung gemäß Anspruch 1 oder 2, wobei das Oxetanharz oder die Verbindung ein 3-Ethyl-3-hydroxymethyloxetan, ein 3-Ethyl-3-phenoxymethyloxetan, ein Bis(1-ethyl(3-oxetanil))methyl)ether, ein 3-Ethyl-3-(2-ethylhexyloxy)methyl)oxetan, ein 1,4-Bis((3-ethyl-3-oxetanylmethoxy)methyl)-benzen, ein Phenol-Novolak-Oxetan und/oder ein 3-Ethyl-(triethoxysilylpropoxy)-methyl)oxetan ist.

4. Harzzusammensetzung gemäß einem der vorangehenden Ansprüche, wobei der Vinylether ein Divinyl, ein Trivinyl und/oder ein hoher funktionalisierter Vinylether ist.

5. Harzzusammensetzung gemäß einem der vorangehenden Ansprüche, wobei der Vinylether Ethylenglycoldivinylether, Ethylenglycolmonovinylether, Diethylenglycoldivinylether, Triethylenglycolmonovinylether, Triethylenglycoldivinylether, Propylenglycoldivinylether, Dipropylenglycoldivinylether, Butandioldivinylether, Hexandioldivinylether, Cyclohexandimethanoldivinylether, Hydroxyethylmonovinylether, Hydroxymonovinylether und Trimethylolpropantrivinylether und Monovinyletherverbindungen, wie Ethylvinylether, n-Butylvinylether, Isobutylvinylether, Octadecylvinylether, Cyclohexylvinylether, Hydroxybutylvinylether, 2-Ethylhexylvinylether, Cyclohexandimethanolmonovinylether, n-Propylvinylether, Isopropylvinylether, Isopropenylether, o-Propylencarbonat, Dodecylvinylether, Diethylenglycolmonovinylether und/oder Octadecylvinylether ist.

6. Harzzusammensetzung gemäß einem der vorangehenden Ansprüche, wobei das Polycarbonatdiol, Triol oder Polyol durch Reaktion mindestens eines Alkylcarbonat mit mindestens einem des Diols, Triols und/oder Polyols erhältlich ist.

7. Harzzusammensetzung gemäß Anspruch 6, wobei das Alkylcarbonat Dimethylcarbonat und/oder Diethylcarbonat ist.

8. Harzzusammensetzung gemäß einem der vorangehenden Ansprüche, wobei das Polycarbonatdiol ein 2-Butyl-ethyl-1,3-propandiolpolycarbonat oder ein Copolymerpolycarbonat ist, wobei das Diol 2-Butyl-2-ethyl-1,3-propandiol in Kombination mit mindestens einem weiteren Diol, Triol und/oder Polyol ist.

9. Harzzusammensetzung gemäß einem der vorangehenden Ansprüche, wobei mindestens ein kationischer Fotoinitiator ein Jodonium, ein Sulfonium, ein Halonium, ein Sulfoxonium, ein Diazonium und/oder ein Metallocensalz ist.

10. Harzzusammensetzung gemäß einem der vorangehenden Ansprüche, welche weiterhin mindestens ein organisches oder anorganisches Pigment, Füller und/oder Farbstoff umfasst.

11. Harzzusammensetzung gemäß einem der vorangehenden Ansprüche, wobei das wahlweise enthaltene radikalisch polymerisierbare Monomer oder Oligomer ein Acrylatmonomer oder Oligomer ist.

12. Harzzusammensetzung gemäß Anspruch 11, wobei das Acrylatmonomer Hexandiol-di(meth)acrylat, Trimethylolpropan-tri(meth)acrylat, Alkylenoxid-modifiziertes Glycerol-tri(meth)acrylat, Alkylenoxid-modifiziertes Neopentylglycol-di(meth)acrylat, Alkylenoxid-modifiziertes Trimethylolpropantri(meth)acrylat, Alkylenoxid-modifiziertes Pentaerythritol-tetra(meth)acrylat, Ditrimethylolpropantetra(meth)acrylat und/oder Dipentaerythritolpenta(meth)acrylat ist.

13. Harzzusammensetzung gemäß Anspruch 11, wobei das Acrylatoligomer ein Epoxy(meth)acrylat, ein Polyester(meth)acrylat, ein Polyether(meth)acrylat, ein Melamin(meth)acrylat, ein Urethan(meth)acrylat, ein Polycarbonat(meth)acrylat, ein dendritisches (Meth)acrylat und/oder ein ungesättigter Polyester ist.

14. Harzzusammensetzung gemäß einem der vorangehenden Ansprüche, wobei der wahlweise enthaltene freie radikalische Fotoinitiator ein Benzoin oder ein Benzoinderivat, Acetophenon, Benzil oder ein Benzilketal, ein Anthrachinon, Triphenylphosphin, ein Benzoylphosphinoxid, ein Benzophenon, ein Thioxanthon, ein Xanthon, ein Acridinderivat, ein Phenacenderivat und/oder ein Chinoxalinderivat ist.

15. Harzzusammensetzung gemäß einem der vorangehenden Ansprüche, welche mindestens einen Sensibilisator umfasst, der mindestens einen kationischen Fotoinitiator sensibilisiert und so dessen Reaktivität erhöht.

16. Harzzusammensetzung gemäß Anspruch 15, wobei der Sensibilisator in einer Menge von beispielsweise 0,1 bis 5,0 Gew.% vorliegt.

17. Harzzusammensetzung gemäß Anspruch 15 oder Anspruch 16, wobei der Sensibilisator 1-Chloro-4-propoxythioxanthon ist.

18. Harzzusammensetzung gemäß einem der vorangehenden Ansprüche, welche weiterhin mindestens einen Stabilisator umfasst, wie mindestens ein Kohlenwasserstoffcarbonsäuresalz eines Metalls der Gruppe IA oder IIA.

19. Harzzusammensetzung gemäß Anspruch 18, wobei der Stabilisator Natriumbicarbonat, Kaliumbicarbonat und/oder Rubidiumcarbonat ist.

20. Harzzusammensetzung gemäß einem der vorangehenden Ansprüche, wobei das mindestens eine Polycarbonatdiol Neopentylglycolpolycarbonatdiol oder 2-Butyl-2-ethyl-1,3-propandiolpolycarbonatdiol ist.

21. Harzzusammensetzung gemäß einem der vorangehenden Ansprüche, welche eine dekorative und/oder schützende Beschichtung oder eine Lackzusammensetzung, eine Tinte, wie eine Druckertinte, Zusammensetzung oder eine Haftzusammensetzung ist.

22. Harzzusammensetzung gemäß einem der Ansprüche 1 bis 20, welche eine Schnellprototyp-Entwicklungszusammensetzung ist.

23. Verwendung einer Harzzusammensetzung gemäß einem der Ansprüche 1 bis 20, in einer dekorativen und/oder schützenden Beschichtung oder einem Lack, in einer Tinte oder in einem Haftmittel.

24. Verwendung einer Harzzusammensetzung gemäß einem der Ansprüche 1 bis 20 zur Schnellprototypentwicklung.

## Revendications

1. Composition de résine durcissable par la lumière ultraviolette comprenant:
a) 25 - 95 % en poids d'au moins une résine ou composé époxy ou époxyde cycloaliphatique, laquelle résine ou composé a un ou plusieurs groupes époxyde à trois chaînons, d'au moins un vinyléther et/ou d'au moins une résine ou composé d'oxétane ayant un ou plusieurs groupes oxétane à quatre chaînons et/ou d'un mélange de ceux-ci,
b) 1 - 40 % en poids d'au moins un polycarbonate diol, triol et/ou polyol où le diol, triol et/ou polyol est choisi parmi le 1,4-butanediol, le néopentylglycol, le 2-butyl-2-éthyl-1,3-propanediol, le diéthylèneglycol, le 1,6-hexanediol, le triéthylèneglycol, le 1,3-diméthanol-cyclohexane, le 1,4-diméthanol-cyclohexane, le diméthanoltricyclodécane, le triméthyloléthane, le triméthylolpropane, le pentaérythritol, le ditriméthyloléthane, le ditriméthylolpropane, le dipentaérythritol et/ou l'anhydroenneaheptitol,
c) 0,1 - 10 % en poids d'au moins un photoinitiateur cationique, et éventuellement
d) 1 - 70 % en poids d'au moins un monomère ou oligomère polymérisable par polymérisation radicalaire et/ou d'un mélange de deux-ci,
et/ou
e) 0,1 - 10 % en poids d'au moins un photoinitiateur radicalaire.

2. Composition de résine selon la revendication 1 où ladite résine ou composé époxy ou époxyde cycloaliphatique est un carboxylate de 4-époxy-cyclohexylméthyl-3,4-époxycyclohexane, un carboxylate de 3,4-époxy-1-méthyl-cyclohexylméthyl-3,4-époxy-1-méthylcyclohexane, un carboxylate de 6-méthyl-3,4-époxycyclohexylméthyl-6-méthyl-3,4-époxycyclohexane, un carboxylate de 3,4-époxy-3-méthylcyclohexylméthyl-3,4-époxy-3-méthylcyclohexane et/ou un carboxylate de 3,4-époxy-5-méthylcyclohexylméthyl-3,4-époxy-5-méthyl-cyclohexane.

3. Composition de résine selon la revendication 1 ou 2 où ladite résine ou composé d'oxétane est un 3-éthyl-3-hydroxyméthyloxétane, un 3-éthyl-3-phénoxyméthyloxétane, un bis(1-éthyl-(3-oxétanil))méthyl)éther, un 3-éthyl-3-(2-éthylhexyloxy)méthyl)oxétane, un 1,4-bis((3-éthyl-3-oxétanylméthoxy)méthyl)-benzène, un oxétane novolaque du phénol et/ou un 3-éthyl-(triéthoxysilyl-propoxy)-méthyl)oxétane.

4. Composition de résine selon l'une quelconque des revendications précédentes où ledit vinyléther est un divinyléther, un trivinyléther et/ou un vinyléther de fonctionnalité supérieure.

5. Composition de résine selon l'une quelconque des revendications précédentes ou ledit vinyléther est l'éthylèneglycol divinyléther, l'éthylèneglycol monovinyléther, le diéthylèneglycol divinyléther, le triéthylèneglycol monovinyléther, le triéthylèneglycol divinyléther, le propylèneglycol divinyléther, le dipropylèneglycol divinyléther, le butanediol divinyléther, l'hexanediol divinyléther, le cyclohexanediméthanol divinyléther, l'hydroxyéthyl monovinyléther, l'hydroxynonyl monovinyléther et le triméthylolpropane trivinyléther, et des composés monovinyléthers comme l'éthylvinyléther, le n-butylvinyléther, l'isobutylvinyléther, l'octadécylvinyléther, le cyclohexylvinyléther, l'hydroxy-butylvinyléther, le 2-éthylhexylvinyléther, le cyclohexane-diméthanol monovinyléther, le *n*-propylvinyléther, l'*iso*-propylvinyléther, l'*iso*-propényléther, le carbonate de o-propylène, le dodécylvinyléther, le diéthylèneglycol monovinyléther et/ou l'octadécylvinyléther.

6. Composition de résine selon l'une quelconque des revendications précédentes où ledit polycarbonatediol, triol ou polyol peut être obtenu par réaction d'au moins un carbonate d'alkyle avec au moins l'un desdits diol, triol et/ou polyol.

7. Composition de résine selon la revendication 6 où ledit carbonate d'alkyle est le carbonate de diméthyle et/ou le carbonate de diéthyle.

8. Composition de résine selon l'une quelconque des revendications précédentes où ledit polycarbonatediol est un polycarbonate de 2-butyl-2-éthyl-1,3-propanediol ou un polycarbonate copolymère où ledit diol est le 2-butyl-2-éthyl-1,3-propanediol en combinaison avec au moins un autre diol, triol et/ou polyol.

9. Composition de résine selon l'une quelconque des revendications précédentes où ledit au moins un photoinitiateur cationique est un sel d'iodonium, de sulfonium, d'halonium, de sulfoxonium, de diazonium et/ou de métallocène.

10. Composition de résine selon l'une quelconque des revendications précédentes comprenant en outre au moins un pigment organique ou inorganique, une charge et/ou une matière colorante.

11. Composition de résine selon l'une quelconque des revendications précédentes où ledit monomère ou oligomère polymérisable par polymérisation radicalaire facultatif est un monomère ou oligomère d'acrylate.

12. Composition de résine selon la revendication 11 où ledit monomère d'acrylate est le di(méth)acrylate d'hexanediol, le tri(méth)acrylate de triméthylolpropane, le tri(méth)acrylate de glycérol modifié avec un oxyde d'alkylène, le di(méth)acrylate de néopentylglycol modifié avec un oxyde d'alkylène, le tri(méth)acrylate de triméthylolpropane modifié avec un oxyde d'alkylène, le tétra(méth)acrylate de pentaérythritol modifié avec un oxyde d'alkylène, le tétra(méth)acrylate de ditriméthylolpropane et/ou le penta(méth)acrylate de dipentaérythritol.

13. Composition de résine selon la revendication 11 où ledit oligomère d'acrylate est un époxy (méth)acrylate, un polyester (méth)acrylate, un polyéther (méth)acrylate, un mélamine (méth)acrylate, un uréthane (méth)acrylate, un polycarbonate (méth)acrylate, (méth)acrylate dendritique et/ou un polyester insaturé.

14. Composition de résine selon l'une quelconque des revendications précédentes où ledit photoinitiateur radicalaire facultatif est la benzoïne ou un dérivé de benzoïne, l'acétophénone, le benzile ou un benzile cétal, une anthraquinone, la triphénylphosphine, un oxyde de benzoylphosphine, une benzophénone, une thioxanthone, une xanthone, un dérivé d'acridine, un dérivé de phénazène et/ou un dérivé de quinoxaline.

15. Composition de résine selon l'une quelconque des revendications précédentes comprenant en outre au moins un sensibilisateur sensibilisant ledit au moins un photoinitiateur cationique en augmentant ainsi sa réactivité.

16. Composition de résine selon la revendication 15 où ledit sensibilisateur est présent en une quantité de, par exemple, 0,1 - 5,0 % en poids.

17. Composition de résine selon la revendication 15 ou la revendication 16 où ledit sensibilisateur est la 1-chloro-4-propoxy-thioxanthone.

18. Composition de résine selon l'une quelconque des revendications précédentes comprenant en outre au moins un stabilisant, comme au moins un sel d'acide carboxylique hydrocarboné et d'un métal du groupe IA ou IIA.

19. Composition de résine selon la revendication 18 où ledit stabilisant est le bicarbonate de sodium, le bicarbonate de potassium et/ou le carbonate de rubidium.

20. Composition de résine selon l'une quelconque des revendications précédentes où ledit au moins un polycarbonate diol est le néopentylglycol polycarbonate diol ou le 2-butyl-2-éthyl-1,3-propanediol polycarbonate diol.

21. Composition de résine selon l'une quelconque des revendications précédentes où c'est une composition de revêtement ou de vernis décoratif et/ou protecteur, une composition d'encre, comme une encre d'impression, ou une composition adhésive.

22. Composition de résine selon l'une quelconque des revendications 1 - 20 où c'est une composition de prototypage rapide.

23. Utilisation d'une composition de résine selon l'une quelconque des revendications 1 - 20 dans un revêtement ou vernis décoratif et/ou protecteur, dans une encre ou dans un adhésif.

24. Utilisation d'une composition de résine selon l'une quelconque des revendications 1 - 20 pour le prototypage rapide.
